# EUROPEAN PATENT SPECIFICATION

(11) **EP 2 306 638 B1**
(45) Date of publication and mention of the grant of the patent: **16.11.2011**
(21) Application number: 09171862.7
(22) Date of filing: 30.09.2009
(51) Int. Cl.: H03F 1/02, H04B 1/04

(54) **Envelope tracking amplifier arrangement**
Hüllkurvennachführungsverstärkungsanordnung
Agencement d'amplificateur de suivi d'enveloppes

(43) Date of publication of application: 06.04.2011
(73) Proprietor: Alcatel Lucent, 75007 Paris (FR)
(72) Inventor: Wiegner, Dirk, 71409, Schwaikheim (DE); Templ, Wolfgang, 74372, Sersheim (DE); Machinal, Robin, 70173, Stuttgart (DE)
(74) Representative: Schmidt, Werner Karl

(56) References cited:
- EP-A1- 1 394 932
- GB-A- 2 438 749
- US-A1- 2006 199 553
- US-A1- 2009 097 591

## Description

### Field of the Invention

The invention relates to the field of telecommunications, more specifically to power amplification of RF signals in base stations, in particular using the Envelope Tracking concept.

### Background

This section introduces aspects that may be helpful in facilitating a better understanding of the invention. Accordingly, the statements of this section are to be read in this light and are not to be understood as admissions about what is in the prior art or what is not in the prior art.

In order to improve efficiency of (single-band as well as multi-band, single-standard as well as multi-standard) power amplifiers and thus base stations, the Envelope Tracking concept is a very promising approach. The Envelope Tracking concept combines a RF power amplifier with an envelope modulator, providing a modulated supply voltage to a supply voltage input terminal of the RF power amplifier, for example to the Drain feed of a field effect transistor.

However, the overall Envelope Tracking amplifier performance (including efficiency) is dependent on an accurate delay compensation between the RF signal and the modulated supply voltage provided to the RF power transistor. If the modulated supply voltage and the RF signal are not in phase, signal distortions (non-linearity), reduced efficiency and reduced output power may occur. Also, an offset between the RF signal and the modulated supply voltage should be kept as low as possible in order to attain high efficiency.

US 2009/0097591 A1 discloses an envelope tracking arrangement according to the preamble of claim 1.

### Summary

The present invention is directed to addressing the effects of one or more of the problems set forth above. The following presents a simplified summary of the invention in order to provide a basic understanding of some aspects of the invention. This summary is not an exhaustive overview of the invention. It is not intended to identify key or critical elements of the invention or to delineate the scope of the invention. Its sole purpose is to present some concepts in a simplified form as a prelude to the more detailed description that is discussed later.

One aspect of the invention relates to an envelope tracking arrangement, comprising: a power transistor for amplification of an RF signal, a modulator for providing a modulated supply voltage as a dynamic bias voltage to the power transistor, the modulated supply voltage being dependent on an envelope of the RF signal, and a signal processing unit, in particular a digital signal processing unit, for comparing at least one error measure of the RF input and output signals of the power transistor, thus allowing to perform at least one of a delay adjustment and an offset adjustment between the RF signal and the modulated supply voltage. The RF input and output signals are tapped in an input coupling unit at an input of the power transistor and in an output coupling unit at an output of the power transistor, respectively.

As it is difficult to find a suitable measure (not being influenced by other transceiver/amplifier components such as mixer, reconstruction filter, ...) for assessing whether or not the RF signal and the supply voltage are in phase, it is proposed to branch the RF signal (possibly directly) at the input and the output of the RF power transistor using suitable couplers, and to calculate an appropriate error measure for both the input RF signal and the output RF signal.

In case that the values of the error measures are similar, the delay (and offset) are typically correctly adjusted and need not be modified. In case that a significant difference is observed, the delay and/or the offset adjustment has to be modified. When using different error measures, it may be possible to adjust the voltage offset and the delay offset independently from one another.

In one embodiment, the digital signal processing unit is adapted to compare at least one of an error vector magnitude (EVM) and a modulation error ratio as an error measure of the RF input and output signals. The error vector magnitude is a measure of in-band distortions and thus provides a good measure for the delay / offset compensation of Envelope Tracking systems. The error vector magnitude is based on the difference of an ideal constellation point and an actual constellation point in the I-Q (in-phase and quadrature-phase) plane of a baseband signal which is used as a basis for generating the RF signal. Another error measure which may be used for the present purposes is the modulation error ratio, being closely related to the error vector magnitude, but calculated based on the average signal power, whereas the EVM is calculated based on the power of a reference. In both cases, typically down-conversion and conversion of the analogue RF input and output signals to the digital domain has to be performed. It will be understood that other types of error measures may be used for the present purposes as well, the error measures being in particular related to the (digital) modulation of the baseband signal.

In a further embodiment, the envelope tracking arrangement further comprises a feedback path from the output coupling unit to the digital signal processing unit. The feedback path is typically adapted to convert the analogue RF output signal back to the digital domain (also performing down-conversion of the RF signal), thus facilitating calculation of the error measure and linearization of the amplification, as discussed below.

In one improvement, the digital signal processing (DSP) unit is adapted for performing linearization of the amplification of the power transistor. The feedback signal provided by the feedback path may be used for improving linearization of the amplification provided by the power amplifier. For this purpose, the DSP unit may perform digital pre-distortion of a baseband signal which is up-converted to the RF domain by shifting the center frequency of the baseband signal to a carrier frequency, typically in the GHz range. The up-converted (analogue) RF signal generated from the baseband signal is then provided as an RF input signal to the power transistor.

In one improvement, the feedback path comprises a switch for alternately providing the tapped RF input signal and the tapped RF output signal to the digital signal processing unit for performing at least one of the delay adjustment and the offset adjustment. Typically, the feedback path is connected to the output coupling unit for providing feedback about the RF output signal to the digital signal processing unit in order to perform the digital pre-distortion. However, when the delay and/or offset adjustment is performed, the switch is used for alternately connecting the input and output coupling units to the digital signal processing unit, thus allowing to calculate the error measure for both the RF input and output signals. Moreover, by providing the RF input signal to the digital signal processing unit, the digital pre-distortion may be improved, as additional information related e.g. to the linearity of a pre-amplifier stage may be taken into account.

It will be understood that during the delay alignment procedure, or the offset alignment procedure, respectively, the pre-distortion typically does not work adaptively. However, since delay and offset compensation only have to be performed when starting the ET system and at certain points of operation (for re-alignment), the feedback path may be used for the linearization most of the time.

In another embodiment, the feedback path further comprises at least one of an analog-to-digital converter, a mixer, a filter, and an intermediate frequency amplifier. The mixer may be a broadband mixer being used for performing down-conversion of the RF signal e.g. to an intermediate frequency. The downconverted signal may then be filtered before being amplified by an intermediate frequency amplifier. An A/D converter then converts the feedback signal back to the digital domain. It will be understood, however, that other ways of implementing the feedback path do exist which may not necessarily use an intermediate frequency.

In a further embodiment, the signal processing unit is adapted to minimize a difference of the error measures between the RF input and output signals for adjusting at least one of the delay and the offset between the RF signal and the modulated supply voltage. Optimum delay/offset between the RF signal and the modulated supply voltage can be attained when the difference in the error measures is minimized. One skilled in the art will appreciate that the delay/offset adjustment may also be performed e.g. in the envelope modulator and/or in a power amplifier which comprises the power transistor.

In one improvement, the signal processing unit is adapted to adjust a timing delay between an envelope signal to be provided to the modulator and a baseband signal to be provided to an RF path leading to the power transistor. The digital signal processing unit is ideally suited for performing the delay/offset adaptation, as the DSP unit generates both the baseband signal which is provided (after up-conversion) as the RF input signal to the power transistor and the envelope signal which is provided as an input to the envelope modulator, thus having direct impact on the modulated supply voltage provided to the power transistor. Thus, the DSP unit may set the delay/offset between both signals in dependence of the feedback such that the error measure is minimized. In such a way, it is also possible to perform an adaptive amplifier adjustment to compensate for ageing effects or temperature variations during operation of the envelope tracking arrangement.

Further aspects of the invention relate to a base station comprising an envelope tracking arrangement as described above, and to a communication network comprising at least one such base station. The communication network and base station equipped with such an envelope tracking arrangement show improved envelope tracking amplifier performance (in particular with regard to efficiency) by appropriately adjusting the delay/offset of the RF signal and the modulated supply voltage, respectively.

A further aspect of the invention relates to a method for performing at least one of a delay adjustment and an offset adjustment between an RF signal being amplified in a power transistor and a modulated supply voltage which is provided as a bias voltage to the power transistor, the modulated supply voltage being dependent on an envelope signal of the RF signal. The method comprises the following steps: comparing at least one error measure of the RF signal at an input and an output of the power transistor, and performing at least one of the delay adjustment and of the offset adjustment by minimizing a difference between the error measures of the RF input and output signals, wherein the RF input and output signals are tapped in an input coupling unit at an input of the power transistor and in an output coupling unit at an output of the power transistor, respectively . The error measure may in particular be related to the digital modulation of the RF signal, respectively, of a baseband signal which is up-converted to the RF signal. For example, the error measure may be an error vector magnitude or a modulation error ratio.

In one variant, for performing linearization of the amplification of the power transistor, the RF output signal may be provided via a feedback path to a digital signal processing unit. The digital signal processing unit may be adapted for performing digital pre-distortion of a baseband signal which is provided as an RF input signal to the power transistor (after D/A conversion and up-conversion).

In a further variant, for performing at least one of the delay compensation and the offset compensation, the method includes the step of providing the RF input and output signals alternately to the digital signal processing unit, preferably by using the feedback path. By switching between the RF input and output signals, only one feedback path is required for performing the comparison. It will be understood that as the switching can be performed much more rapidly than a possible drift of the delay and/or voltage offset, the short delay introduced by the switching is not critical for the present purposes.

In another variant, for adjusting at least one of the timing delay and the offset between the RF signal and the modulated supply voltage, the method further comprises adjusting at least one of a timing delay and an offset between an envelope signal to be provided to the modulator and a baseband signal to be provided as an (up-converted) RF signal to the power transistor. Thus, the delay and/or offset adjustment may be performed e.g. in a (digital) signal processing unit which is adapted to generate both the envelope signal and the baseband signal.

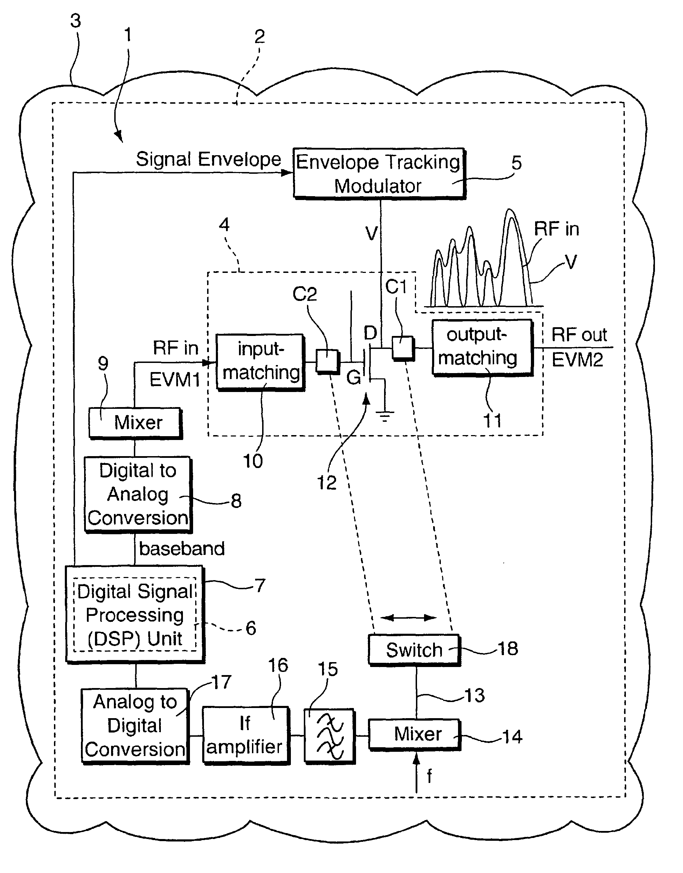

Further features and advantages are stated in the following description of exemplary embodiments, with reference to the figures of the drawing, which shows significant details, and are defined by the claims. The individual features can be implemented individually by themselves, or several of them can be implemented in any desired combination.

### Brief Description of the Figures

Exemplary embodiments are shown in the diagrammatic drawing and are explained in the description below. The following are shown:
- **Fig.**: shows a schematic diagram of an embodiment of an envelope tracking arrangement for delay / offset adjustment between an RF signal and a modulated supply voltage provided to a power transistor.

### Description of the Embodiments

The functions of the various elements shown in the Figure, including any functional blocks labeled as 'processors', may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term 'processor' or `controller' should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

The only **Figure** shows an envelope tracking (transmitter) arrangement **1** of a base station **2** which is part of a communications network **3.** The arrangement 1 comprises a power amplifier **4** and an envelope tracking modulator **5,** both of which are connected to a digital signal processing unit **6** being arranged in a baseband part **7** of the base station 2.

The digital signal processing unit 6 is adapted for generating a digital baseband signal **"baseband"** which is provided to a digital-to-analog conversion unit **8** and to a mixer **9** for up-conversion, thus forming a RF signal **"RF** in" at a carrier frequency being typically above e.g. 300 MHz or in the GHz range. The up-converted RF signal "RF in" is then provided as an input signal to the power amplifier 4.

The power amplifier 4 comprises an input matching network **10** for input impedance matching, an output matching network **11** for output impedance matching, and a power transistor **12** which is arranged between the input and output matching networks 10, 11. The amplified RF signal **"RF out"** is provided from the power amplifier **4** to a transmit antenna (not shown) for radio transmission.

The digital signal processing unit 6 is adapted to calculate an envelope signal **"signal envelope"** of the RF signal "RF in" to be provided to the amplifier 4 based on the digital baseband signal "baseband". The envelope tracking modulator 5 generates a modulated supply voltage **V** based on the input signal, the modulated supply voltage V being provided to an supply voltage input terminal (Drain terminal **D**) of the power transistor 12. The modulated supply voltage V is used for improving efficiency of the amplification of the power transistor 12.

The envelope tracking arrangement 1 also comprises a feedback path **13** leading from a first coupler **C1** being arranged at the output terminal D of the power transistor 12 to the digital signal processing unit 6. The feedback path 13 comprises a broadband mixer **14** for down-conversion of the amplified RF signal "RF out" to an intermediate frequency **f,** a filter **15** for filtering unwanted frequency components, an intermediate frequency amplifier **16,** and an analog-to-digital converter **17** for providing a digital feedback signal to the digital signal processing unit 6. The digital signal processing unit 6 is adapted for performing digital pre-distortion of the baseband signal "baseband" based on the feedback, thus allowing linearization of the amplification of the power transistor 12.

The feedback path 13 also comprises a switch **18** for alternately connecting the first coupler C1 or a second coupler C2 being arranged at an input terminal (gate terminal **G**) of the power transistor 12 to the feedback path 13. Thus, the RF input signal "RF in" and the RF output signal "RF out" of the envelope tracking / transmitter arrangement 1 are tapped directly at the RF power transistor's input and output terminals G, D, respectively. However, one skilled in the art will appreciate that the input and output signals "RF in" and "RF out" may also be tapped before the input matching network 10 and after the output matching network 11, respectively.

When the delay between the modulated supply voltage V and the RF signal "RF in" has to be adjusted, or the offset between the modulated supply voltage V and the RF signal "RF in" has to be adjusted (see the Figure for a comparison of both signals), the tapped RF input and output signals "RF in", "RF out" are transferred alternately to the digital signal processing unit 6 via the feedback path 13, which is usually used for amplifier linearization (see above). This is enabled by the switch 18 which connects temporally alternately either the RF input signal "RF in" or the RF output signal "RF out" to the mixer 14 of the feedback path 13.

It will be understood that during the time delay alignment procedure, or the offset alignment procedure, respectively, the adaptive pre-distortion is disabled. However, this is not critical, since delay and offset compensation only have to be performed when starting the transmitter arrangement 1 and at certain points during its operation time (for re-alignment). Thus, the linearization may use the feedback path 13 for most of the time for adaptive pre-distortion of the baseband signal "baseband".

During the alignment procedure, in order to achieve optimum delay compensation or offset adjustment for the envelope tracking arrangement 1, the digital processing unit 6 calculates an error vector magnitude **EVM1** derived from the RF input signal "RF in", and an error vector magnitude **EVM2** derived from the RF output signal "RF out" and compares both values. The error vector magnitude is a measure of in-band distortions and thus provides a good measure for delay compensation/offset compensation of Envelope Tracking (ET) systems. Optimum delay / offset can thus be attained by minimizing the difference between the input error vector magnitude EVM1 and the output error vector magnitude EVM2. One skilled in the art will appreciate that different error measures may be used for performing the adjustment, for example a modulation error ratio, or other error measures which are typically related to the digital modulation of the baseband signal in the digital signal processing unit 6.

Typically, both a timing delay and/or an offset between the envelope signal "signal envelope" and the baseband signal "baseband", the latter being provided (after up-conversion) as an RF input signal "RF in" to the power transistor 12, are adjusted until the difference between the respective error vector magnitudes EVM1, EVM2 is minimized. The envelope tracking arrangement 1 as described above is thus provided with an internal feedback loop for internal timing delay and offset adjustment. Both timing and offset adjustment may in particular be performed during operation of the arrangement 1 allowing adaptive adjustment taking ageing effects or temperature variations into account.

The delay adjustment and the offset adjustment between the RF signal "RF in" and the modulated supply voltage V is performed in the digital signal processing unit 6 in an indirect way, namely by modifying the envelope signal "signal envelope" and the baseband signal "baseband". It will be understood, however, that the delay adjustment and/or the offset adjustment may alternatively be performed in the modulator 5 and/or in the RF power amplifier 4, possibly directly modifying the RF signal "RF in" and/or the modulated supply voltage V.

In the present example, the power transistor 12 is implemented as a field effect transistor. However, the power transistor 12 may also be implemented as a bipolar transistor. When using a field effect transistor, transistor elements based on metal oxide semiconductor (MOS) technology or High Electron Mobility transistors (HEMT) using, for instance, gallium nitride (GaN) as a semiconductor material may be used. Alternatively, the power transistor may e.g. be implemented as a high-voltage hetero-junction bipolar transistor (HVHBT) using e.g. gallium arsenide (GaAs) as a semiconductor material.

In summary, in the way described above, overall envelope tracking amplifier performance (in particular with regard to efficiency) can be optimized and, due to the coupling close to the transistor, no negative effects (distortions etc.) due to other transceiver components as e.g. mixer, etc. affect the procedure . An additional benefit is that only small modifications of the hardware are required, as a feedback path which is typically also provided in conventional systems can be used, the latter only being supplemented by an additional input coupler and a switch.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

The description and drawings merely illustrate the principles of the invention. It will thus be appreciated that those skilled in the art will be able to devise various arrangements that, although not explicitly described or shown herein, embody the principles of the invention and are included within its scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. Envelope tracking arrangement (1), comprising:
a power transistor (12) for amplification of an RF signal (RF in), a modulator (5) for providing a modulated supply voltage (V) as a dynamic bias voltage to the power transistor (12), the modulated supply voltage (V) being dependent on an envelope signal (signal envelope) of the RF signal (RF in), and
a signal processing unit, in particular a digital signal processing unit (6), for comparing at least one error measure (EVM1, EVM2) of the RF input and output signals (RF in, RF out) of the power transistor (12) in order to perform at least one of a delay adjustment and an offset adjustment between the RF signal (RF in) and the modulated supply voltage (V),
**characterized in that**
the RF input and output signals (RF in, RF out) are tapped in an input coupling unit (C2) at an input of the power transistor (12) and in an output coupling unit (C1) at an output of the power transistor (12), respectively.

2. Envelope tracking arrangement according to claim 1, wherein the digital signal processing unit (6) is adapted to compare at least one of an error vector magnitude (EVM1, EVM2) and a modulation error ratio as an error measure of the RF input and output signals (RF in, RF out).

3. Envelope tracking arrangement according to claim 1 or 2, further comprising a feedback path (13) from the output coupling unit (C1) to the digital signal processing unit (6).

4. Envelope tracking arrangement according to claim 3, wherein the digital signal processing unit (6) is adapted for performing linearization of the amplification of the power transistor (12).

5. Envelope tracking arrangement according to claim 3 or 4, wherein the feedback path (13) comprises a switch (18) for alternately providing the tapped RF input signal (RF in) and the tapped RF output signal (RF out) to the digital signal processing unit (6) for performing at least one of the delay adjustment and the offset adjustment.

6. Envelope tracking arrangement according to any one of claims 3 to 5, wherein the feedback path (13) further comprises at least one of an analog-to-digital converter (17), a mixer (14), a filter (15), and an intermediate frequency amplifier (16).

7. Envelope tracking arrangement according to any one of the preceding claims, wherein the signal processing unit (6) is adapted to minimize a difference of the error measures (EVM1, EVM2) between the RF input and output signals (RF in, RF out) for adjusting at least one of the delay and the offset between the RF signal (RF in) and the modulated supply voltage (V).

8. Envelope tracking arrangement according to any one of the preceding claims, wherein the digital signal processing unit (6) is adapted to adjust at least one of a timing delay and a voltage offset between an envelope signal (signal envelope) to be provided to the modulator (5) and a baseband signal (baseband) to be provided as an RF input signal (RF in) to the power transistor (12).

9. Base station (2) comprising at least one Envelope Tracking arrangement (1) according to any one of the preceding claims.

10. Wireless communication network (3), comprising at least one base station (2) according to claim 9.

11. Method for performing at least one of a delay adjustment and an offset adjustment between an RF signal (RF in) being amplified in a power transistor (12) and a modulated supply voltage (V) which is provided as a dynamic bias voltage to the power transistor (12), the modulated supply voltage (V) being dependent on an envelope signal (signal envelope) of the RF signal (RF in), the method comprising:
comparing at least one error measure (EVM1, EVM2) of the RF signal (RF in, RF out) at an input and an output of the power transistor (12), and
performing at least one of the delay adjustment and the offset adjustment by minimizing a difference between the error measures (EVM1, EVM2) of the RF input and output signals (RF in, RF out),
**characterized in that,**
the RF input and output signals (RF in, RF out) are tapped in an input coupling unit (C2) at an input of the power transistor (12) and in an output coupling unit (C1) at an output of the power transistor (12), respectively.

12. Method according to claim 11, wherein the error measure is chosen from the group consisting of: an error vector magnitude (EVM1, EVM2) and a modulation error ratio.

13. Method according to claim 11 or 12, further comprising: for performing linearization of the amplification of the power transistor (12), providing the RF output signal (RF out) via a feedback path (13) to a digital signal processing unit (6).

14. Method according to claim 13, further comprising: for performing at least one of the delay compensation and the offset compensation, providing the RF input and output signals (RF in, RF out) alternately to the digital signal processing unit (6), preferably by using the feedback path (13).

15. Method according to claim 13 or 14, wherein for adjusting at least one of the timing delay and the offset between the RF signal (RF in) and the modulated supply voltage (V), the method further comprises: adjusting at least one of a timing delay and an offset between an envelope signal (signal envelope) to be provided to the modulator (5) and a baseband signal (baseband) to be provided as an RF input signal (RF in) to the power transistor (12).

## Patentansprüche

1. Hüllkurvennachführungsanordnung (1), umfassend:
Einen Leistungstransistor (12) zur Verstärkung eines RF-Signals (RF in),
einen Modulator (5) zur Bereitstellung einer modulierten Versorgungsspannung (V) als eine dynamische Vorspannung an den Leistungstransistor (12), wobei die modulierte Versorgungsspannung (V) von einem Hüllkurvensignal (Signalhüllkurve) des RF-Signals (RF in) abhängig ist, und
eine Signalverarbeitungseinheit, insbesondere eine digitale Signalverarbeitungseinheit (6), zum Vergleichen mindestens eines Fehlermaßes (EVM1, EVM2) des RF-Eingangssignals und des RF-Ausgangssignals (RF in, RF out) des Leistungstransistors (12), um mindestens einen Verzögerungsabgleich oder einen Versatzabgleich zwischen dem RF-Signal (RF in) und der modulierten Versorgungsspannung (V) durchzuführen, **dadurch gekennzeichnet, dass** das RF-Eingangssignal und das RF-Ausgangssignal (RF in, RF out) jeweils in einer Eingangskopplungseinheit (C2) an einem Eingang des Leistungstransistors (12) und in einer Ausgangskopplungseinheit (C1) an einem Ausgang des Leistungstransistors (12) abgegriffen werden.

2. Hüllkurvennachführungsanordnung nach Anspruch 1, wobei die digitale Signalverarbeitungseinheit (6) dazu ausgelegt ist, mindestens entweder eine Fehlervektorgröße (EVM1, EVM2) oder ein Modulationsfehlerverhältnis als ein Fehlermaß des RF-Eingangssignals und des RF-Ausgangssignals (RF in, RF out) zu vergleichen.

3. Hüllkurvennachführungsanordnung nach Anspruch 1 oder 2, weiterhin umfassend einen Rückkopplungspfad (13) von der Ausgangskopplungseinheit (C1) zu der digitalen Signalverarbeitungseinheit (6).

4. Hüllkurvennachführungsanordnung nach Anspruch 3, wobei die digitale Signalverarbeitungseinheit (6) für die Linearisierung der Verstärkung des Leistungstransistors (12) ausgelegt ist.

5. Hüllkurvennachführungsanordnung nach Anspruch 3 oder 4, wobei der Rückkopplungspfad (13) einen Switch (18) für das wechselweise Bereitstellen des abgegriffenen RF-Eingangssignals (RF in) und des abgegriffenen RF-Ausgangssignals (RF out) an die digitale Signalverarbeitungseinheit (6) zum Durchführen mindestens entweder des Verzögerungsabgleichs oder des Versatzabgleichs umfasst.

6. Hüllkurvennachführungsanordnung nach einem beliebigen der Ansprüche 3 bis 5, wobei der Rückkopplungspfad (13) weiterhin mindestens entweder einen Analog-Digital-Wandler (17), einen Mischer (14), einen Filter (15) oder einen Zwischenfrequenzverstärker (16) umfasst.

7. Hüllkurvennachführungsanordnung nach einem beliebigen der vorstehenden Ansprüche, wobei die Signalverarbeitungseinheit (6) dazu ausgelegt ist, eine Differenz der Fehlermaße (EVM1, EVM2) zwischen dem RF-Eingangssignal und dem RF-Ausgangssignal (RF in, RF out) zu minimieren, um mindestens entweder die Verzögerung oder den Versatz zwischen dem RF-Signal (RF in) und der modulierten Versorgungsspannung (V) abzugleichen.

8. Hüllkurvennachführungsanordnung nach einem beliebigen der vorstehenden Ansprüche, wobei die digitale Signalverarbeitungseinheit (6) dazu ausgelegt ist, mindestens entweder eine Zeitverzögerung oder einen Spannungsversatz zwischen einem an den Modulator (5) bereitzustellenden Hüllkurvensignal (Signalhüllkurve) und einem als ein RF-Eingangssignal (RF in) an den Leistungstransistor (12) bereitzustellenden Basisbandsignal (Basisband) (12) abzugleichen.

9. Basisstation (2) mit mindestens einer Hüllkurvennachführungsanordnung (1) gemäß einem beliebigen der vorstehenden Ansprüche.

10. Drahtloses Kommunikationsnetzwerk (3) mit mindestens einer Basisstation (2) gemäß Anspruch 9.

11. Verfahren zum Durchführen mindestens entweder eines Verzögerungsabgleichs oder eines Versatzabgleichs zwischen einem in einem Leistungstransistor (12) verstärkten RF-Signal (RF in) und einer modulierten Versorgungsspannung (V), welche als eine dynamische Vorspannung an den Leistungstransistor (12) bereitgestellt wird, wobei die modulierte Versorgungsspannung (V) von einem Hüllkurvensignal (Signalhüllkurve) des RF-Signals (RF in) abhängig ist, wobei das Verfahren umfasst:
Vergleichen mindestens eines Fehlermaßes (EVM1, EVM2) des RF-Signals (RF in, RF out) an einem Eingang und einem Ausgang des Leistungstransistors (12),
und
Durchführen mindestens des Verzögerungsabgleichs oder des Versatzabgleichs durch Minimieren einer Differenz zwischen den Fehlermaßen (EVM1, EVM2) des RF-Eingangssignals und des RF-Ausgangssignals (RF in, RF out), **dadurch gekennzeichnet, dass**
das RF-Eingangssignal und das RF-Ausgangssignal (RF in, RF out) jeweils in einer Eingangskopplungseinheit (C2) an einem Eingang des Leistungstransistors (12) und in einer Ausgangskopplungseinheit (C1) an einem Ausgang des Leistungstransistors (12) abgegriffen werden.

12. Verfahren nach Anspruch 11, wobei das Fehlermaß aus einer Gruppe bestehend aus: Einer Fehlervektorgröße (EVM1, EVM2) und einem Modulationsfehlerverhältnis gewählt wird.

13. Verfahren nach Anspruch 11 oder 12, weiterhin umfassend: Für das Durchführen der Linearisierung der Verstärkung des Leistungstransistors (12), Bereitstellen des RF-Ausgangssignals (RF out) über einen Rückkopplungspfad (13) an eine digitale Signalverarbeitungseinheit (6).

14. Verfahren nach Anspruch 13, weiterhin umfassend: Für das Durchführen mindestens entweder des Verzögerungsausgleichs oder des Versatzausgleichs, wechselweises Bereitstellen des RF-Eingangssignals und des RF-Ausgangssignals (RF in, RF out) an die digitale Signalverarbeitungseinheit (6), vorzugsweise unter Benutzung des Rückkopplungspfads (13).

15. Verfahren nach Anspruch 13 oder 14, wobei das Verfahren für den Abgleich der Zeitverzögerung und des Versatzes zwischen dem RF-Signal (RF in) und der modulierten Versorgungsspannung (V) weiterhin umfasst: Abgleichen mindestens entweder einer Zeitverzögerung oder eines Versatzes zwischen einem an den Modulator (5) bereitzustellenden Hüllkurvensignal (Signalhüllkurve) und einem als ein RF-Eingangssignal (RF in) an den Leistungstransistor (12) bereitzustellenden Basisbandsignal (Basisband).

## Revendications

1. Système de suivi d'enveloppes (1), comprenant :
un transistor de puissance (12) pour l'amplification d'un signal RF (RF d'entrée),
un modulateur (5) pour fournir une tension d'alimentation modulée (V) comme tension de polarisation dynamique au transistor de puissance (12), la tension d'alimentation modulée (V) dépendant d'un signal d'enveloppe (enveloppe du signal) du signal RF (RF d'entrée), et
une unité de traitement de signal, en particulier une unité de traitement de signal numérique (6), pour comparer au moins une mesure d'erreur (EVM1, EVM2) des signaux RF d'entrée et de sortie (RF d'entrée, RF de sortie) du transistor de puissance (12) afin d'effectuer au moins un réglage parmi un réglage du retard et un réglage du décalage entre le signal RF (RF d'entrée) et la tension d'alimentation modulée (V), **caractérisé en ce que**
les signaux RF d'entrée et de sortie (RF d'entrée, RF de sortie) sont dérivés dans une unité de couplage d'entrée (C2) à une entrée du transistor de puissance (12) et dans une unité de couplage de sortie (C1) à une sortie du transistor de puissance (12), respectivement.

2. Système de suivi d'enveloppes selon la revendication 1, dans lequel l'unité de traitement de signal numérique (6) est adaptée pour comparer au moins une valeur parmi une amplitude du vecteur d'erreur (EVM1, EVM2) et un rapport d'erreur de modulation comme une mesure d'erreur des signaux RF d'entrée et de sortie (RF d'entrée, RF de sortie).

3. Système de suivi d'enveloppes selon la revendication 1 ou 2, comprenant en outre un trajet de contre-réaction (13) entre l'unité de couplage de sortie (C1) et l'unité de traitement de signal numérique (6).

4. Système de suivi d'enveloppes selon la revendication 3, dans lequel l'unité de traitement de signal numérique (6) est adaptée pour effectuer une linéarisation de l'amplification du transistor de puissance (12).

5. Système de suivi d'enveloppes selon la revendication 3 ou 4, dans lequel le trajet de contre-réaction (13) comprend un commutateur (18) pour fournir en alternance le signal RF d'entrée dérivé (RF d'entrée) et le signal RF de sortie dérivé (RF de sortie) à l'unité de traitement de signal numérique (6) pour effectuer au moins un réglage parmi le réglage du retard et le réglage du décalage.

6. Système de suivi d'enveloppes selon l'une quelconque des revendications 3 à 5, dans lequel le trajet de contre-réaction (13) comprend en outre au moins un dispositif parmi un convertisseur analogique/numérique (17), un mélangeur (14), un filtre (15) et un amplificateur à fréquence intermédiaire (16).

7. Système de suivi d'enveloppes selon l'une quelconque des revendications précédentes, dans lequel l'unité de traitement de signal (6) est adaptée pour réduire au minimum une différence des mesures d'erreur (EVM1, EVM2) entre les signaux RF d'entrée et de sortie (RF d'entrée, RF de sortie) pour régler au moins une valeur parmi le retard et le décalage entre le signal RF (RF d'entrée) et la tension d'alimentation modulée (V).

8. Système de suivi d'enveloppes selon l'une quelconque des revendications précédentes, dans lequel l'unité de traitement de signal numérique (6) est adaptée pour régler au moins une valeur parmi un retard de synchronisation et un décalage de tension entre un signal d'enveloppe (enveloppe du signal) à fournir au modulateur (5) et un signal en bande de base (bande de base) à fournir comme signal RF d'entrée (RF d'entrée) au transistor de puissance (12).

9. Station de base (2), comprenant au moins un système de suivi d'enveloppes (1) selon l'une quelconque des revendications précédentes.

10. Réseau de communication sans fil (3), comprenant au moins une station de base (2) selon la revendication 9.

11. Procédé pour effectuer au moins un réglage parmi un réglage du retard et un réglage du décalage entre un signal RF (RF d'entrée) amplifié dans un transistor de puissance (12) et une tension d'alimentation modulée (V) qui est fournie comme tension de polarisation dynamique au transistor de puissance (12), la tension d'alimentation modulée (V) dépendant d'un signal d'enveloppe (enveloppe du signal) du signal RF (RF d'entrée), le procédé comprenant les étapes suivantes :
comparer au moins une mesure d'erreur (EVM1, EVM2) du signal RF (RF d'entrée, RF de sortie) à une entrée et une sortie du transistor de puissance (12), et
effectuer au moins un réglage parmi le réglage du retard et le réglage du décalage en réduisant au minimum une différence entre les mesures d'erreur (EVM1, EVM2) des signaux RF d'entrée et de sortie (RF d'entrée, RF de sortie), **caractérisé en ce que**
les signaux RF d'entrée et de sortie (RF d'entrée, RF de sortie) sont dérivés dans une unité de couplage d'entrée (C2) à une entrée du transistor de puissance (12) et dans une unité de couplage de sortie (C1) à une sortie du transistor de puissance (12), respectivement.

12. Procédé selon la revendication 11, dans lequel la mesure d'erreur est sélectionnée dans le groupe constitué : d'une amplitude du vecteur d'erreur (EVM1, EVM2) et d'un rapport d'erreur de modulation.

13. Procédé selon la revendication 11 ou 12, comprenant en outre : pour effectuer une linéarisation de l'amplification du transistor de puissance (12), fournir le signal RF de sortie (RF de sortie), par l'intermédiaire d'un trajet de contre-réaction (13), à une unité de traitement de signal numérique (6).

14. Procédé selon la revendication 13, comprenant en outre : pour effectuer au moins une compensation parmi la compensation du retard et la compensation du décalage, fournir les signaux RF d'entrée et de sortie (RF d'entrée, RF de sortie) en alternance à l'unité de traitement de signal numérique (6), de préférence en utilisant le trajet de contre-réaction (13).

15. Procédé selon la revendication 13 ou 14, dans lequel pour régler au moins une valeur parmi le retard de synchronisation et le décalage entre le signal RF (RF d'entrée) et la tension d'alimentation modulée (V), le procédé comprend en outre l'étape suivante : régler au moins une valeur parmi un retard de synchronisation et un décalage entre un signal d'enveloppe (enveloppe du signal) à fournir au modulateur (5) et un signal en bande de base (bande de base) à fournir comme signal RF d'entrée (RF d'entrée) au transistor de puissance (12).
